**Europäisches Patentamt**

**European Patent Office**

**Office européen des brevets**

(19)

(11) Veröffentlichungsnummer: **0 252 540 B1**

(12) **EUROPÄISCHE PATENTSCHRIFT**

(45) Veröffentlichungstag der Patentschrift: **09.09.92**

(21) Anmeldenummer: **87200988.1**

(22) Anmeldetag: **26.05.87**

(51) Int. Cl.⁵: **H03F 1/30**

(54) Schaltungsanordnung zum Einstellen eines Referenzpegels in einem periodischen Signal.

(30) Priorität: **05.06.86 DE 3618939**

(43) Veröffentlichungstag der Anmeldung:
**13.01.88 Patentblatt  88/02**

(45) Bekanntmachung des Hinweises auf die
Patenterteilung:
**09.09.92 Patentblatt  92/37**

(84) Benannte Vertragsstaaten:
**DE FR GB IT**

(56) Entgegenhaltungen:
**DE-C- 3 214 756**
**US-A- 3 750 038**
**US-A- 4 296 437**

**PATENT ABSTRACTS OF JAPAN, Band 7, Nr.
236 (E-205)[1381], 20. Oktober 1983; & JP-
A-58 124 373 (NIPPON HOSO KYOKAI)
23-07-1983**

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB IT**

(72) Erfinder: **Kröner, Klaus
Immenhorstweg 94
W-2000 Hamburg 65(DE)**
Erfinder: **Wölber, Jörg
Taubenstrase 32
W-2080 Pinneberg(DE)**

(74) Vertreter: **Peters, Carl Heinrich, Dipl.-Ing. et al
Philips Patentverwaltung GmbH Wendenstrasse 35 Postfach 10 51 49
W-2000 Hamburg 1(DE)**

# Beschreibung

Die Erfindung bezieht sich auf eine Schaltungsanordnung zum Verstärken eines periodischen Signale und zum Einstellen eines darin enthaltenen Referenzpegels durch Ermittlung dieses Referenzpegels, mit einer Grenzwertstufe, in der das verstärkte Signal mit einem wenigstens nahezu konstanten Grenzwert verglichen wird und die eine Umladeanordnung wechselweise in einen von zwei Zuständen schaltet, je nachdem, ob der Wert des periodischen Signale den Grenzwert über- oder unterschreitet, wobei die Umladeanordnung Ströme zum wechselweisen Auf- oder Entladen eines Speichers derart liefert, daß auf dem Speicher ein dem Referenzpegel wenigstens annähernd entsprechender Mittelwert auftritt, und mit einer Verstärkerstufe, die wenigstens ein Verstärkerelement zum Verstärken des Signals aufweist und der der Mittelwert vom Speicher zum Einstellen des im Signal enthaltenen Referenzpegels zugeführt wird.

Eine derartige Schaltungsanordnung ist aus der DE-C 32 14 756, z.B. Fig. 3 oder 4 mit zugehöriger Beschreibung, bekannt. Solche Schaltungsanordnungen werden bevorzugt als Klemmschaltungen bei der Aufbereitung von Fernsehsignalen in Fernsehempfangsanordnungen verwendet. Im Gegensatz zu der sogenannten Zwangsklemmung, bei der das Fernsehsignal während kurzer Zeitintervalle mit einem extern zugeführten Klemmimpuls abgetastet wird, benötigen die Schaltungsanordnungen der eingangs genannten Art keinen extern zugeführten Klemmimpuls und sind wesentlich unempfindlicher gegen Störungen im Fernsehsignal. Der einzustellende Referenzpegel im Fernsehsignal läßt sich dabei in einfacher Weise durch Festlegung des Verhältnisses der Ströme zum Auf- oder Entladen des Speichers wählen. Es ist dabei für ein einwandfreies Funktionieren der Schaltungsanordnung wichtig, daß dieses einmal gewählte Verhältnis zwischen den Strömen zum Auf- und Entladen keinen Schwankungen unterworfen wird, da diese Schwankungen sich als Schwankungen im einzustellenden Referenzpegel, d.h. in dem auf dem Speicher auftretenden Mittelwert, bemerkbar machen können.

Derartige Schwankungen können beispielsweise durch den Eingangsstrom einer in der Schaltungsanordnung enthaltenen Verstärkerstufe, die mit dem Speicher verbunden ist, hervorgerufen werden, sofern dieser Eingangsstrom mit einem zwar periodischen, jedoch in seiner Amplitude wechselnden Signal schwankt. Unterschiedliche Ströme können ferner auch durch Fertigungstoleranzen in der Verstärkerstufe oder durch Temperaturschwankungen auftreten, die insbesondere die Verstärkungsfaktoren von in der Verstärkerstufe enthaltenen Verstärkerelementen beeinflussen. Es hat sich gezeigt, daß dieser letztgenannte Effekt bedeutende Auswirkungen haben kann.

Zum Unterdrücken des Einflusses der beschriebenen Schwankungen wird daher der Strom zum Entladen des Speichers wesentlich größer gewählt als der den genannten Schwankungen unterworfene, von der Verstärkerstufe stammende Strom. Ist dies beispielsweise der Eingangsstrom der Verstärkerstufe, der nicht beliebig klein gewählt werden kann, um die Bandbreite des von der Verstärkerstufe verstärkten periodischen Signals nicht mehr als zulässig einzuengen, wird auch ein Mindestwert für den Strom zum Entladen des Speichers vorgegeben. Das bedingt auch eine Mindestgröße des Stromes zum Aufladen einerseits und des Speichers, beispielsweise eines Kondensators, andererseits, um einerseits die Aufladung des Speichers bewerkstelligen zu können und um andererseits eine Umladung des Speichers während einer Periode des Signals durch den Strom zum Entladen möglichst gering zu halten, da derartige Entladevorgänge den Verlauf des periodischen Signals verzerren.

Ist das periodische Signal beispielsweise ein Fernsehsignal, in dem außer den die Periode bestimmenden Zeilensynchronsignalen auch Bildsynchronsignale auftreten, würde bei einem zu kleinen Speicher, beispielsweise Kondensator, darin eine zu große Abweichung von dem ermittelten Referenzpegel auftreten.

Andererseits bedingen große Ströme eine größere Dimensionierung aller von ihnen durchflossenen Bauteile. Insbesondere benötigen auch als Kondensatoren bestimmter Mindestgröße ausgebildete Speicher einen minimalen Platzbedarf. Dadurch wird eine Integration der beschriebenen Schaltungsanordnung auf einem Halbleiterplättchen erschwert.

Die Erfindung hat die Aufgabe, eine Schaltungsanordnung der eingangs genannten Art derart auszubilden, daß ohne Verluste in der Genauigkeit der Ermittlung des Referenzpegels eine Verringerung der Baugröße, insbesondere des Speichers, erzielt und somit eine möglichst vollständige Integration der Schaltungsanordnung auf einem Halbleiterplättchen ermöglicht wird.

Die Aufgabe wird nach der Erfindung dadurch gelöst, daß die Umladeanordnung dem Speicher die Ströme über eine Kompensationsstufe zuführt, die den Strom zum Aufladen und/oder den zum Entladen mit einem Kompensationsfaktor umsetzt, der derart gewählt ist, daß das Verhältnis zwischen dem Strom zum Aufladen und dem zum Entladen vom Verstärkungsfaktor unabhängig ist.

Die Erfindung hat den Vorteil, daß der Strom zum Entladen des Speichers nicht mehr aus den beschriebenen Toleranzgründen erheblich größer als die an der Verstärkerstufe auftretenden Ströme, insbesondere als deren Eingangsströme, gewählt werden muß, sondern vielmehr durch einen in seiner Größe diesen Strömen entsprechenden Strom oder durch diesen Strom selber gebildet werden kann. Dabei gleicht die Kompensationsstufe alle durch Schwankungen oder Toleranzen des Verstärkungsfaktors entstehenden Abweichungen im Verhältnis zwischen den Strömen zum Auf- und und Entladen aus, so daß dieses Verhältnis stets einem für den jeweils zu ermittelnden Referenzpegel festgelegten Stromverhältnis entspricht. Im Gegensatz zu den bekannten Schaltungen muß dann nicht mehr beispielsweise der Eingangsstrom der Verstärkerstufe verringert werden, um den Strom zum Entladen des Speichers zu reduzieren. Dadurch werden insbesondere Einschränkungen in der Übertragungsbandbreite der Verstärkerstufe vermieden. Vorzugsweise ist dabei der Kompensationsfaktor proportional zu einer Potenz des Verstärkungsfaktors des Verstärkerelements gewählt.

Durch Verringerung des Stromes zum Entladen des Speichers und damit auch desjenigen zum Aufladen können zum einen die von diesen Strömen durchflossenen Bauelemente der Schaltungsanordnung räumlich kleiner dimensioniert werden, zum anderen aber kann insbesondere der Speicher an die verringerten Ströme angepaßt werden. Das bedeutet z.B. bei einem als Kondensator ausgebildeten Speicher, der zusammen mit den übrigen Teilen der Schaltungsanordnung auf einem Halbleiterplättchen integriert werden soll, eine Reduzierung der Fläche der Platten des Kondensators und damit der für den Kondensator auf dem Halbleiterplättchen benötigten Fläche um das Maß, um das die Ströme zum Auf- und und Entladen des Kondensators verringert worden sind.

Nach einer weiteren Ausgestaltung der erfindungsgemäßen Schaltungsanordnung sind die Verstärkerelemente aus einem oder mehreren Transistoren aufgebaut, aus deren Stromverstärkungen sich der Verstärkungsfaktor ableitet. Nach einer vorteilhaften Weiterbildung umfaßt dann die Kompensationsstufe wenigstens einen Transistor, dessen Stromverstärkung zu den Stromverstärkungen der Verstärkerelemente und/oder dem Verstärkungsfaktor ein konstantes Verhältnis bildet. Insbesondere, wenn sowohl die Verstärkerelemente als auch die Kompensationsstufe auf einem gemeinsamen Halbleiterplättchen integriert sind, lassen sich mit einer derartigen Anordnung nicht nur Temperatureinflüsse auf die Stromverstärkungen, sondern auch Fertigungstoleranzen, wie z.B. ungenaue Positionierung von Ätzmasken oder Abweichungen in der Dotierung bei der Herstellung des Halbleiterplättchens kompensieren, weil diese Einflüsse in einem integrierten Schaltkreis wenigstens nahezu auf alle Teile desselben in gleicher Weise einwirken. Bei einem Aufbau der Schaltungsanordnung mit diskreten Schaltelementen und anschließendem Abgleich der Schaltung ist in jedem Fall die dann noch notwendige Kompensation von Temperaturschwankungen möglich.

Nach einer Fortbildung der Erfindung umfaßt der Speicher wenigstens einen ersten Kondensator, der außerdem einen Koppelkondensator bildet, über den das periodische Signal der Verstärkerstufe zugeführt wird. Der Speicher erfüllt damit zugleich die Funktion einer Gleichstromabtrennung, die bevorzugt zwischen der erfindungsgemäßen Schaltungsanordnung und ihr vorgeschalteten Signalverarbeitungsstufen eingefügt ist. Damit kann im Vergleich zu einer Schaltungsanordnung mit gesondertem Koppelkondensator ein Schaltungsteil eingespart werden und somit eine beträchtliche Fläche auf einem Halbleiterplättchen mit einem integrierten Schaltkreis oder ein gesondert davon anzubringendes Bauteil und ein Anschlußkontakt an diesem integrierten Schaltkreis. Bei einer derartigen Schaltungsanordnung hat die durch die Erfindung erreichte Verringerung der Ströme zum Auf- und Entladen des Speichers, d.h. des Koppelkondensators, weiterhin den Vorteil, daß damit eine Verringerung des Spannungsabfalls erzielt wird, den diese Ströme im Quellenwiderstand der der erfindungsgemäßen Schaltungsanordnung vorgeschalteten Signalverarbeitungsstufe verursachen. Eine dadurch hervorgerufene Verzerrung des periodischen Signals wird somit durch die Erfindung ebenfalls beträchtlich verringert.

Nach einer anderen Fortbildung der Erfindung umfaßt der Speicher wenigstens einen zweiten Kondensator, der mit seinem ersten Anschluß mit einem Bezugspunkt und mit seinem zweiten Anschluß mit einem Vergleichswerteingang der Verstärkerstufe verbunden ist. Der zweite Kondensator liefert so insbesondere eine Steuerspannung zur Einstellung des Arbeitspunktes an die Verstärkerstufe.

Nach einer weiteren Ausgestaltung der Erfindung ist im Verhältnis zu dem Strom zum Entladen die Kapazität des Kondensators derart gewählt, daß er durch den Strom während einer Periode des Signals nicht merklich umgeladen wird. Bei vorgegebener Größe des Stromes zum Entladen und einer höchstzulässigen Umladung des Kondensators ist damit der Mindestwert seiner Kapazität festgelegt. Durch die erfindungsgemäße Reduzierung des Entladestroms kann dieser Kapazitätswert oder die höchstzulässige Umladung nun beträchtlich verringert werden, was entweder zu einer Verringerung der Abmessungen der Schaltungsanordnung oder zu einer Verringerung der Fehler im periodischen Signal oder zu einer Kombination aus beidem benutzt werden kann.

Der gleiche Vorteil kann nach einer anderen Ausgestaltung der erfindungsgemäßen Schaltungsanordnung dadurch erreicht werden, daß diese sowohl einen ersten als auch einen zweiten Kondensator aufweist, deren Kapazitäten im Verhältnis zu den zugehörigen Strömen zum Entladen derart gewählt sind, daß Umladungen durch diese Ströme während einer Periode des Signals einander in ihren Wirkungen auf das Signal aufheben. Bei einer derartigen Anordnung ist es nämlich nicht mehr erforderlich, die höchstzulässigen Umladungen der Kondensatoren jeweils für sich genommen derart zu begrenzen, daß der Einfluß jeder Umladung allein keinen merkbaren Einfluß auf das periodische Signal hat. Vielmehr können ausdrücklich größere Umladungen zugelassen werden, da sich deren Wirkungen auf das Signal beispielsweise dadurch herausheben, daß die Verstärkerstufe als Differenzverstärker ausgebildet ist und jeweils einer der Kondensatoren mit jeweils einem der Eingänge dieses Differenzverstärkers verbunden ist. Bei gleichmäßigen Entladungen auf beiden Kondensatoren wird deren Einfluß am Ausgang des Differenzverstärkers unterdrückt. Damit können dann beide Kondensatoren noch einmal wesentlich kleinere Flächen aufweisen und sind damit noch besser zu einer Integration mit den übrigen Schaltungsteilen auf einem Halbleiterplättchen geeignet.

Nach einer weiteren Ausgestaltung dieser Schaltungsanordnung ist das Aufladen des ersten Kondensators gegenüber dem Aufladen des zweiten Kondensators in jeder Periode des Signals um einen bestimmten Bruchteil der insgesamt für die Aufladung zur Verfügung stehenden Zeitdauer verzögert. Dadurch erreicht der zweite Kondensator vor dem ersten Kondensator seinen endgültigen Ladezustand, den er bei Beginn des Entladens inne hat. Die am zweiten Kondensator anliegende Spannung kann dann einen definierten Vergleichswert - z.B. an einem Vergleichswerteingang der Verstärkerstufe - bilden, durch den das Aufladen des ersten Kondensators exakt bis zu einem definierten Ladezustand geführt werden kann. Die Spannung auf dem zweiten Kondensator wirkt also wie ein "Anschlag" für die Spannung auf dem ersten Kondensator.

Nach einer anderen Weiterbildung der Erfindung ist zwischen dem zweiten Anschluß des zweiten Kondensators und dem Vergleichswerteingang eine Impedanzwandlerstufe angeordnet. Durch diese kann insbesondere der Strom am Vergleichswerteingang, der beispielsweise durch die Basis eines Transistors gebildet wird, in einem oder in mehreren Schritten herabgesetzt werden, so daß nur noch ein sehr kleiner Strom zum Speisen des Vergleichswerteingangs benötigt wird. Da an diesem Eingang im wesentlichen nur Gleichströme auftreten, ist durch ein Verringern dieser Ströme keine Einschränkung in der Bandbreite der Verstärkerstufe zu befürchten. Wenn jedoch der herabgesetzte Strom dem zweiten Kondensator zum Entladen entnommen oder zugeführt wird, ist damit eine weitere Verringerung der Große dieses Kondensators möglich. Er kann dann beispielsweise mit auf dem Halbleiterplättchen integriert werden. Damit läßt sich der bisher benötigte zusätzliche Anschlußkontakt an dem integrierten Schaltkreis einsparen.

Einige Ausführungsbeispiele der Erfindung sind in der Zeichnung dargestellt und werden im nachfolgenden näher beschrieben. Es zeigen

Fig. 1      ein Blockschaltbild zur Verdeutlichung des Aufbaus einer erfindungsgemäßen Schaltungsanordnung,

Fig. 2      ein einfaches Ausführungsbeispiel der Erfindung,

Fig. 3      und Fig. 4 zwei Ausführungsbeispiele, in denen der Speicher zugleich als Koppelkondensator dient,

Fig. 5      ein Ausführungsbeispiel der Erfindung mit einem ersten und einem zweiten Kondensator,

Fig. 6      ein Ausführungsbeispiel mit einer Impedanzwandlerstufe zum Herabsetzen des Stromes zum Entladen des Speichers.

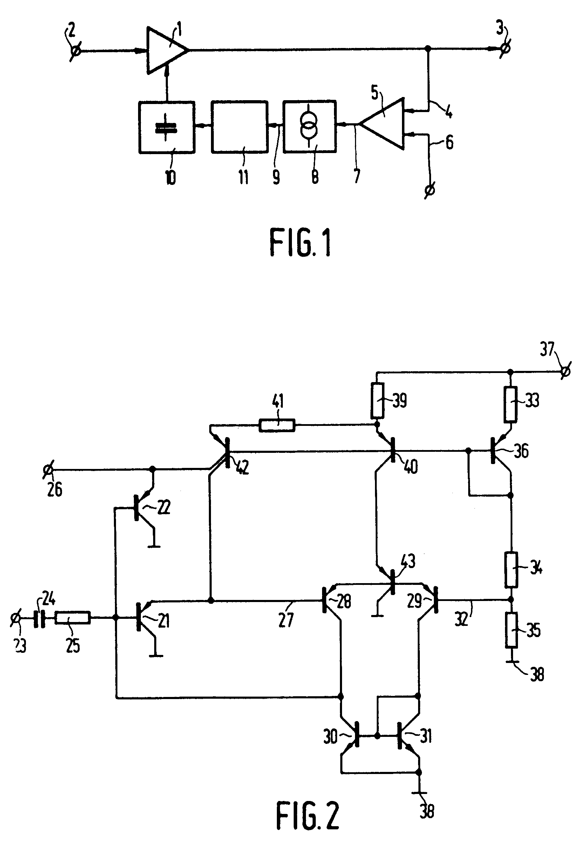

In Fig. 1 ist eine Schaltungsanordnung mit einer Verstärkerstufe 1 dargestellt, der an einem Eingang 2 ein periodisches Signal zugeführt wird und die dieses verstärkt einem Ausgang 3 zuleitet. Der Ausgang 3 ist weiterhin mit einem Signaleingang 4 einer Grenzwertstufe 5 verbunden, der an einem Grenzwerteingang 6 weiterhin ein wenigstens nahezu konstanter Grenzwert zugeleitet wird. Je nachdem, ob das Signal am Signaleingang 4 größer oder kleiner als der Grenzwert ist, gibt die Grenzwertstufe 5 an einem Ausgang 7 ein Schaltsignal ab, das entsprechend zwei Zustände annimmt, durch die eine Umladeanordnung 8, beispielsweise eine umschaltbare Stromquelle, wechselweise in jeweils einen von zwei Zuständen geschaltet wird, in denen sie an ihrem Ausgang 9 einen Strom zum Aufladen bzw. Entladen eines Speichers 10 abgibt. Der Speicher 10 ist z.B. durch einen Kondensator gebildet, der sich auf eine Spannung auflädt, die einem im periodischen Signal enthaltenen Referenzpegel entspricht. Dazu muß das Verhältnis der von der Umladeanordnung 8 abgegebenen Ströme einen bestimmten Wert annehmen. Der Referenzpegel aus dem Speicher 10 wird der Verstärkerstufe 1 zugeführt und stellt dort vorzugsweise einen Gleichstromarbeitspunkt ein.

In diese insoweit aus der DE-PS 32 14 756 bekannte Schaltungsanordnung ist erfindungsgemäß eine Kompensationsstufe 11 eingefügt, über die die Ströme zum Umladen des Speichers 10 vom Ausgang 9 der Umladeanordnung 8 kommend geleitet werden. Wie in den nachfolgend beschriebenen Ausführungsbeispielen im einzelnen näher dargestellt wird, erfolgt in der Kompensationsstufe 11 eine Kompensation einer Abhängigkeit des Stromes zum Entladen des Speichers 10 vom Verstärkungsfaktor der Verstärkerstufe 1 derart, daß das Verhältnis des Stromes zum Aufladen zu dem Strom zum Entladen des Speichers von dem Verstärkungsfaktor unabhängig ist. Dazu können einer der beiden Ströme oder beide mit dem Verstärkungsfaktor oder seinem Kehrwert derart multipliziert werden, daß der Quotient der Ströme eine Konstante ergibt.

Fig. 2 zeigt ein einfaches Ausführungsbeispiel einer derartigen Schaltungsanordnung. Darin bilden zwei Transistoren 21, 22 die Verstärkerstufe 1, der über einen Eingang 23 das periodische Signal zugeführt wird. Im Eingangszweig der Verstärkerstufe 21, 22 ist ein (erster) Kondensator 24 angeordnet, der sowohl einen Speicher als auch einen Koppelkondensator zur Gleichspannungstrennung bildet. Er liegt in Reihe mit einem Vorwiderstand 25 zur Anpassung des Eingangswiderstands der dargestellten Schaltungsanordnung an den Ausgangswiderstand einer nicht dargestellten vorgeschalteten, mit dem Eingang 23 verbundenen Signalverarbeitungsanordnung.

Das periodische Signal vom Eingang 23 wird im Transistor 22 verstärkt und einem Ausgang 26 zugeführt. Zur Entkopplung dieses Ausgangs 26 von den übrigen Schaltungsteilen wird das periodische Signal außerdem im Transistor 21 verstärkt und einem Signaleingang 27 einer aus vier Transistoren 28 bis 31 gebildeten Grenzwertstufe zugeführt. Diese ist ferner über einen Grenzwerteingang 32 mit einem aus drei Widerständen 33 bis 35 sowie einem als Diode geschalteten Transistor 36 gebildeten Spannungsteiler verbunden. Der Spannungsteiler liegt zwischen einem Speisespannungspol 37 und Masse 38. Von ihm werden über einen Widerstand 39 und einen Stromquellentransistor 40 einerseits und über einen weiteren Widerstand 41 sowie einen weiteren Stromquellentransistor 42, der zum Speisen der Transistoren 21, 22 zwei Kollektoren aufweist, andererseits Speiseströme für die Verstärkerstufe 21, 22 und die Grenzwertstufe 28 bis 31 abgeleitet.

Die über die Basis-Emitter-Strecken der Transistoren 21, 22 vom Stromquellentransistor 42 zum ersten Kondensator fließenden Ströme sind von den Stromverstärkungen der Transistoren 21, 22 abhängig. Während der Entladung des ersten Kondensators 24 fließt außer diesen Strömen ein Strom von den Basisanschlüssen der Transistoren 21, 22 über die Kollektor-Emitter-Strecke des Transistors 30 nach Masse. Die Differenz aus diesen Strömen bildet den Strom zum Entladen des ersten Kondensators 24. Da die Transistoren 30 und 31 einen Stromspiegel bilden, wird der Strom durch den Transistor 30 von dem aus dem Stromquellentransistor 40 gelieferten Strom festgelegt. Der Strom durch den Transistor 30 wird von den Strömen an den Basisanschlüssen der Transistoren 21, 22 wenigstens teilweise aufgehoben, wodurch der Strom zum Entladen des ersten Kondensators 24 geringer sein kann als diese Basisströme.

Während der Aufladung des ersten Kondensators 24 in den Zeiträumen, in denen die Spannung am Signaleingang 27 niedriger ist als die Spannung am Grenzwerteingang 32, fließt ein Strom aus dem Kollektor des Stromquellentransistors 40 über den Transistor 28 in den ersten Kondensator 24. Da sich jetzt der Transistor 29 im gesperrten Zustand befindet, fließt auch durch den Transistor 31 und damit wegen der Spiegelung des Stromes auch im Transistor 30 kein Strom. Der erste Kondensator 24 wird daher mit dem gesamten vom Transistor 28 gelieferten Strom aufgeladen.

Wenn der Kollektor des Stromquellentransistors 40 unmittelbar mit den Emittern der Transistoren 28, 29 der Grenzwertstufe 28 bis 31 verbunden wäre, wäre das bei Vorgabe fester Zeiten für die Aufladung und die Entladung des ersten Kondensators sowie eines Referenzpegels resultierende Verhältnis der Ströme zum Auf- bzw. Entladen von der Stromverstärkung der Transistoren abhängig. Daher wurde zwischen den Stromquellentransistor 40 und die Grenzwertstufe 28 bis 31 eine Kompensationsstufe 43 eingefügt. Diese besteht aus einem einfachen Transistor, dessen Emitter der Strom vom Stromquellentransistor 40 zugeführt wird und von dem nur der um die Stromverstärkung verkleinerte Basisstrom der Grenzwertstufe 28 bis 31 zufließt. Dadurch wird in das Stromverhältnis die Stromverstärkung als zusätzlicher Faktor aufgenommen, der die über die Transistoren 21, 22 (Verstärkerstufe) entstehende Abhängigkeit von der Stromverstärkung kompensiert. Das Verhältnis der Ströme zum Auf- und Entladen ist jetzt konstant, d.h. unabhängig von Fertigungstoleranzen und Temperatur.

Die Schaltungsanordnung nach Fig. 2 ist überwiegend mit bipolaren PNP-Transistoren aufgebaut. Bei entsprechender Umpolung der Speisespannungen kann sofort eine dementsprechende Schaltungsanordnung mit NPN-Transistoren gewonnen werden.

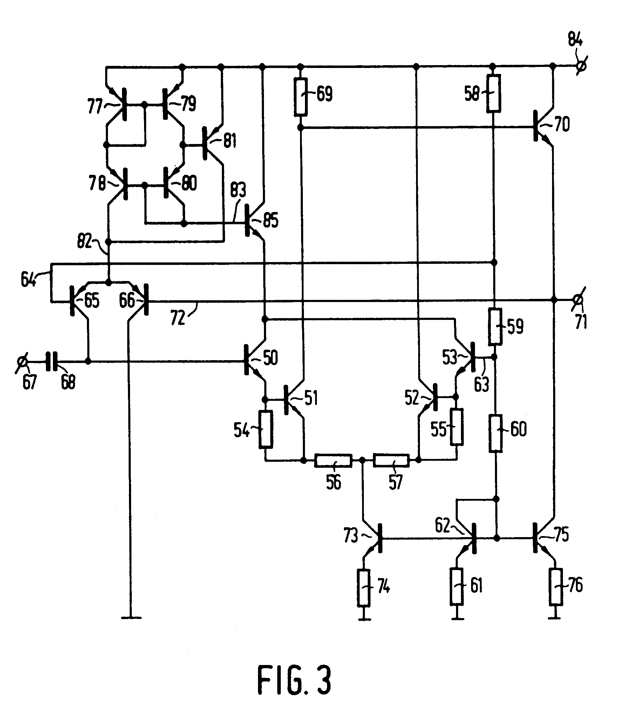

Fig. 3 zeigt ein weiteres Ausführungsbeispiel, in dem die Verstärkerstufe durch einen zweistufigen Differenzverstärker aus den Transistoren 50 bis 53 sowie den Widerständen 54 bis 57 gebildet ist. Ein Spannungsteiler aus vier Widerständen 58 bis 61 und einem als Diode geschalteten Transistor 62 liefert an entsprechenden Anzapfungen konstante Spannungswerte an einen Vergleichwerteingang 63 des Differenzverstärkers 50 bis 57 sowie an einen Grenzwerteingang 64 einer aus zwei Transistoren 65, 66 gebildeten Grenzwertstufe. Das periodische Signal wird vom Eingang 67 über einen als Speicher und Koppelkondensator dienenden (ersten) Kondensator 68 dem Differenzverstärker 50 bis 57 zugeführt. Es wird darin nacheinander in den Transistoren 50 und 51 verstärkt und über einen Arbeitswiderstand 69 und einen Endstufentransistor 70 einem Ausgang 71 zugeleitet, von wo es auch einem Signaleingang 72 der Grenzwertstufe 65, 66 zufließt. Die über den als Diode geschalteten Transistor 62 des Spannungsteilers 58 bis 62 gesteuerten Transistoren 73 bzw. 75 mit ihren Emitterwiderständen 74 bzw. 76 bilden je eine Stromquelle zur Speisung des Differenzverstärkers 50 bis 57 bzw. des Endstufentransistors 70.

In der vorliegenden Schaltungsanordnung fließt der Strom zum Entladen des ersten Kondensators 68 über die mit dem Eingang 67 verbundene Hälfte 50, 51, 54, 56 des Differenzverstärkers und die Stromquelle 73, 74 nach Masse ab. Der Eingangsstrom des Differenzverstärkers 50 bis 57 wird somit unmittelbar als Strom zur Entladung des ersten Kondensators 68 herangezogen. Die Spannung am Ausgang 71 und damit am Signaleingang 72 der Grenzwertstufe 65, 66 ist dann niedriger als die Spannung am Grenzwerteingang 64. Dabei ist zu berücksichtigen, daß das Signal am Ausgang 71 gegenüber dem am Eingang 67 invertiert ist. Der Transistor 65 sperrt; es fließt also nur ein Strom zum Entladen des ersten Kondensators 68. Ein über den Verbindungspunkt der Emitteranschlüsse der Transistoren 65, 66 in die Grenzwertstufe fließender Strom wird über den Transistor 66 nach Masse abgeleitet.

Die Schaltungsanordnung enthält ferner eine Stromspiegelanordnung aus fünf Transistoren 77 bis 81, die einerseits mit einem Speisespannungspol 84 verbunden ist und andererseits einen ersten und einen zweiten Ausgang 82 und 83 aufweist. Derartige Stromspiegelanordnungen sind beispielsweise aus der DE-AS 24 34 947 bekannt. Die an den Ausgängen 82, 83 abgegriffenen Ströme stehen in einem bestimmten Verhältnis zueinander, das durch die Geometrien der Transistoren 77 bis 81 beeinflußt werden kann.

Während der Aufladung des ersten Kondensators 68 ist die Spannung am Signaleingang 72 der Grenzwertstufe 65, 66 höher als der Grenzwert am Grenzwerteingang 64. Dann befindet sich der Transistor 66 im nichtleitenden und der Transistor 65 im leitenden Zustand. Der erste Kondensator 68 wird durch einen von der Stromspiegelanordnung 77 bis 81 über den ersten Ausgang 82 gelieferten Strom aufgeladen. Dieser Strom steht in einem konstanten Verhältnis zu dem am zweiten Ausgang 83 gelieferten Strom. Dieser wird über eine Kompensationsstufe 85, die ebenfalls als Transistor ausgebildet ist, aus der Summe der Kollektorströme der Transistoren 50 und 53 des Differenzverstärkers 50 bis 57 abgeleitet. Da der Kollektorstrom des Transistors 50 mit dem weiterhin über dessen Basis fließenden Strom zur Entladung des ersten Kondensators 68 über die Stromverstärkung verknüpft ist und der dem zweiten Ausgang 83 der Stromspiegelanordnung 77 bis 81 entnommene Strom zu dem Kollektorstrom des Transistors 50 ein bezüglich der Stromverstärkung (der Kompensationsstufe 85) umgekehrtes Verhältnis aufweist, ist der Quotient aus dem über den Transistor 65 zufließenden Aufladestrom und dem Entladestrom durch die Basis des Transistors 50 von der Stromverstärkung unabhängig. In dieser Schaltungsanordnung wird somit nur der Strom zur Aufladung des ersten Kondensators 68 von der Stromverstärkung abhängig gemacht.

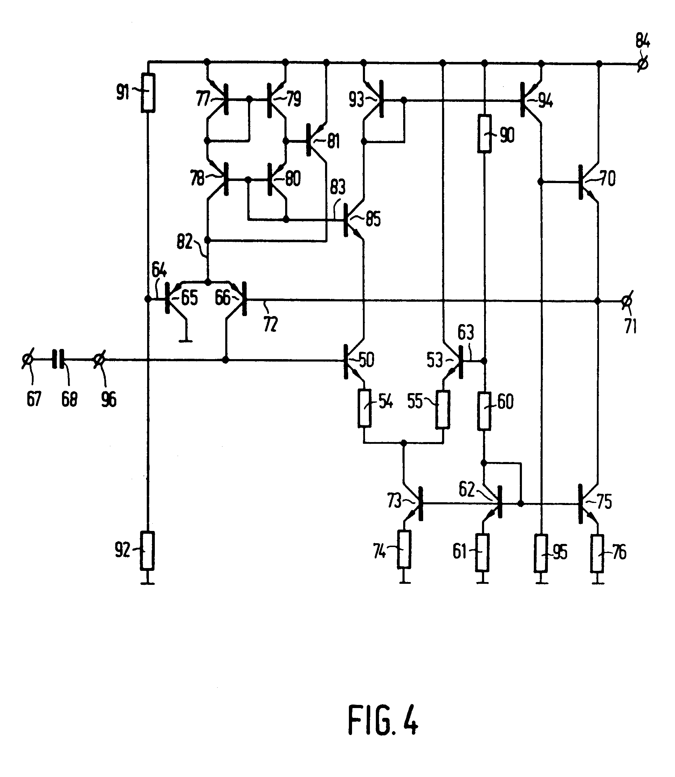

Fig. 4 zeigt eine der Fig. 3 ähnliche Schaltungsanordnung, die für die nicht invertierende Übertragung eines periodischen Signals vom Eingang 67 auf den Ausgang 71 eingerichtet ist. Schaltungsteile, die solchen aus der Fig. 3 entsprechen, sind mit denselben Bezugszeichen wie dort gekennzeichnet. Grenzwertstufe 65, 66 mit Grenzwerteingang 64 und Signaleingang 72, Stromspiegelanordnung 77 bis 81 mit den Ausgängen 82, 83, Speisespannungspol 84 sowie der Endstufentransistor 70 sind von der Schaltungsanordnung nach Fig. 3 im wesentlichen unverändert übernommen. Dagegen enthält die vorliegende Schaltungsanordnung einen lediglich einstufigen Differenzverstärker 50, 53, 54, 55 mit einem Vergleichswerteingang 63. Diese Anordnung entspricht im wesentlichen der ersten Stufe des Differenzverstärkers aus der Schaltungsanordnung nach Fig. 3. Auch die Stromquellen 73, 74 und 75, 76 sind unverändert übernommen, sie und der Vergleichswerteingang 63 werden aus dem nur teilweise abgewandelten Spannungsteiler aus drei Widerständen 60, 61, 90 sowie dem als Diode geschalteten Transistor 62 gespeist. Der Grenzwerteingang 64 der Grenzwertstufe 65, 66 wird jetzt über einen besonderen Grenzwertspannungsteiler aus zwei Widerständen 91 und 92 mit einer den bestimmten Grenzwert bildenden Spannung versorgt.

Das über den Eingang 67 und den ersten Kondensator 68 dem Differenzverstärker 50, 53, 54, 55 zugeleitete Signal wird im Transistor 50 verstärkt und über ein Transistorpaar 93, 94, das als Stromspiegel wirkt, dem Endstufentransistor 70 und über dessen Emitteranschluß dem Ausgang 71 zugeleitet. Ein Widerstand 95 dient als Arbeitswiderstand im Kollektorzweig des Transistors 94.

Bei dieser Schaltungsanordnung werden sowohl das periodische Signal als auch der Kollektorgleichstrom des Transistors 50, aus dem der Strom zum Aufladen des ersten Kondensators 68 abgeleitet wird, über die Kompensationsstufe 85 geführt. Das Signal wird dadurch jedoch in seinem zeitlichen Verlauf nicht beeinflußt.

Für den Fall, daß der erste Kondensator getrennt von den übrigen Bauteilen der Schaltungsanordnung angeordnet wird, ist zwischen diesen ein Verbindungsanschluß 96, beispielsweise als Anschlußkontakt eines integrierten Schaltkreises, vorgesehen.

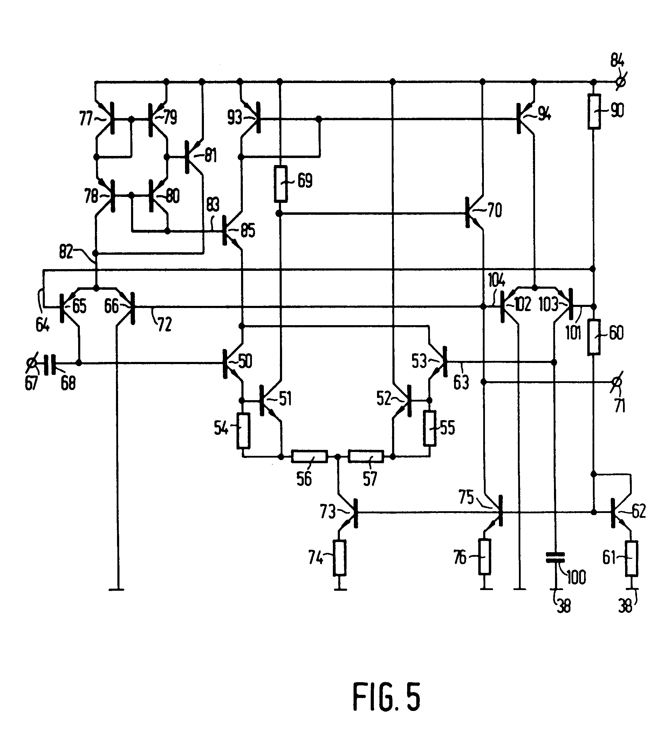

Fig. 5 zeigt ein Ausführungsbeispiel mit einer Schaltungsanordnung, die den ersten Kondensator 68 aufweist, der als Speicher und als Koppelkondensator dient, sowie einen zweiten Kondensator 100, der mit seinem ersten Anschluß mit Masse und mit seinem zweiten Anschluß mit dem Vergleichswerteingang 63 des zweistufigen Differenzverstärkers 50 bis 57 verbunden ist, wobei diese und andere mit gleichen Bezugszeichen versehene Bestandteile der Schaltungsanordnung gleich gekennzeichneten Teilen aus den Fig. 3 und 4 entsprechen. Insbesondere sind der erste Kondensator 68, die Grenzwertstufe 65, 66, die Stromspiegelanordnung 77 bis 81 mit den Ausgängen 82, 83, der Speisespannungspol 84, die Kompensationsstufe 85, der zweistufige Differenzverstärker 50 bis 57, der Endstufentransistor 70 sowie die zu deren Speisung vorgesehenen Stromquellen 73, 74 bzw. 75, 76 mit Fig. 3 identisch, so daß Auf- und Entladung des ersten Kondensators in der Schaltungsanordnung nach Fig. 5 in der gleichen Weise ablaufen wie bei der Schaltungsanordnung nach Fig. 3. Allerdings ist eine Kapazität des ersten Kondensators 68 gegenüber der Ausführung nach Fig. 3 wesentlich verringert, so daß durch die Umladung des ersten Kondensators an ihm eine sägezahnförmige Spannung auftritt, die dieselbe Frequenz wie das periodische Signal aufweist und sich diesem überlagert.

Aus der Schaltungsanordnung nach Fig. 4 ist der Spannungsteiler aus den Widerständen 60, 61, 90 und dem als Diode geschalteten Transistor 62 übernommen. Er liefert jetzt eine konstante Spannung an den Grenzwerteingang 64 der Grenzwertstufe 65, 66 sowie an einen Grenzwerteingang einer weiteren Grenzwertstufe aus zwei Transistoren 102, 103. Entsprechend ist ein Signaleingang 104 mit dem Ausgang 71 verbunden. Somit arbeiten die Grenzwertstufe 65, 66 und die weitere Grenzwertstufe 102, 103 parallel, wobei die weitere Grenzwertstufe 102, 103 dem zweiten Kondensator 100 zugeordnet ist und an ihn einen Strom zum Aufladen liefert, wenn die Spannung am Ausgang 71 die dem Grenzwert entsprechende, vom Spannungsteiler 60, 61, 62, 90 gelieferte Spannung überschreitet. Ein Entladestrom des Kondensators 100 fließt über den Vergleichswerteingang 63 des Differenzverstärkers 50 bis 57. Die Ströme zum Entladen der Kondensatoren 68, 100 und deren Kapazitäten werden derart bestimmt, daß am Vergleichswerteingang 63 die gleiche Sägezahnspannung anliegt wie an der Basis des Transistors 50. Damit kompensieren sich diese Sägezahnspannungen in ihrem Einfluß auf das über dem Arbeitewiderstand 69 und dem Endstufentransistor 70 abgegriffene, verstärkte Signal.

Das Verhältnis zwischen den Strömen zum Aufladen und zum Entladen des ersten Kondensators 68 ist wiederum über die Kompensationsstufe 85 von der Stromverstärkung der in der Schaltung enthaltenen Transistoren unabhängig. Die Summe der Kollektorströme der Transistoren 50 und 53 wird weiterhin über das Transistorpaar 93, 94, von denen der Transistor 93 wie auch in Fig. 4 als Diode geschaltet ist, zur weiteren Grenzwertstufe 102, 103 gespiegelt und tritt dort als Strom zum Aufladen des zweiten Kondensators 100 auf. Im Verhältnis zwischen diesem Strom und dem Strom zum Entladen des zweiten Kondensators 100 ist bei der dargestellten Schaltungsanordnung keine Kompensation des Einflusses der Stromverstärkung der Transistoren vorgesehen. Vielmehr ist das Verhältnis zwischen dem Strom zum Aufladen des zweiten Kondensators 100 und dem Strom zum Aufladen des ersten Kondensators 68, das sich als Quotient aus der Stromverstärkung der Kompensationsstufe 85 und dem konstanten Verhältnis der Ströme an den Ausgängen 82 und 83 der Stromspiegelanordnung 77 bis 81 bestimmt, mit Toleranz größer als 1 gewählt, so daß der zweite Kondensator 100 schneller aufgeladen wird als der erste Kondensator 68. Dadurch erreicht die Spannung am zweiten Kondensator 100 ihren Endwert vor derjenigen am ersten Kondensator 68 und bildet für diese ein definiertes Bezugspotential.

Selbstverständlich kann auch für die Ströme zum Auf- und Entladen des zweiten Kondensators 100 eine Kompensation der Abhängigkeit ihres Verhältnisses von der Stromverstärkung der Transistoren durchgeführt werden. Dazu kann in Abwandlung der in Fig. 5 dargestellten Schaltungsanordnung der Strom in den Verbindungspunkt der Emitteranschlüsse der Transistoren 102 und 103 aus dem zweiten Ausgang 83 der Stromspiegelanordnung 77 bis 81 abgeleitet werden. Das Transistorpaar 93, 94 entfällt dann.

Da die Kondensatoren 68, 100 sehr geringe Kapazitäten aufweisen können, sind sie zusammen mit der übrigen Schaltungsanordnung auf einem Halbleiterplättchen integriert.

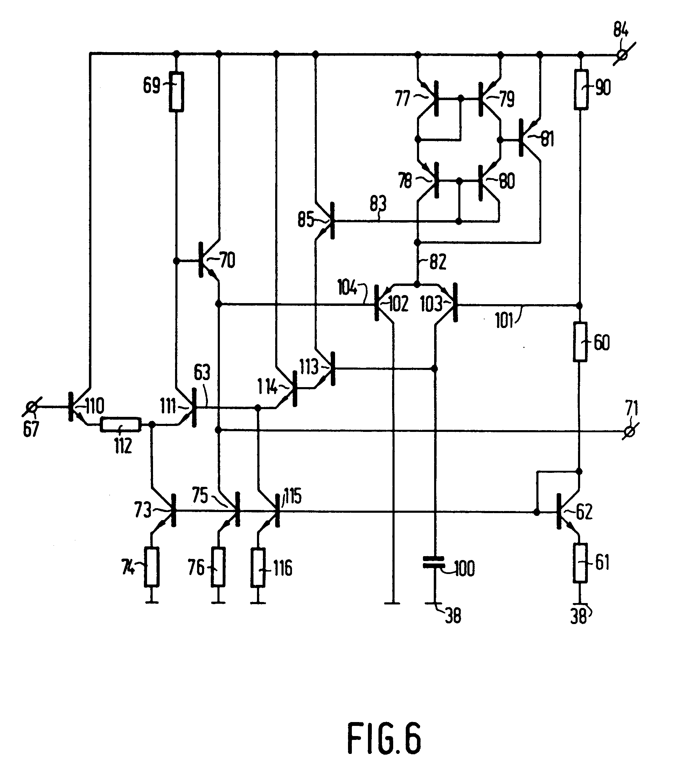

Fig. 6 zeigt eine Ausführungsform mit nur einem (zweiten) Kondensator 100 zwischen Masse und dem Vergleichswerteingang 63 eines einstufigen Differenzverstärkers aus zwei Transistoren 110, 111 und einem Emitterwiderstand 112. Im übrigen sind die mit Teilen der vorstehend beschriebenen Schaltungsanordnungen identischen Bauteile wieder mit denselben Bezugszeichen gekennzeichnet.

Vom Eingang 67 gelangt das periodische Signal über den Differenzverstärker 110 bis 112 an den Arbeitswiderstand 69 und wird über den Endstufentransistor 70 dem Ausgang 71 zugeführt. Zur Stromversorgung des Differenzverstärkers 110 bis 112 und des Endstufentransistor 70 dienen wiederum Stromquellen 73, 74 bzw. 75, 76, die vom Spannungsteiler 60, 61, 62, 90 gesteuert werden, der im übrigen wie in der Schaltung nach Fig. 5 dem Grenzwerteingang 101 der (weiteren) Grenzwertstufe 102, 103 eine konstante Spannung zuleitet. Dem Signaleingang 104 der (weiteren) Grenzwertstufe wird das verstärkte Signal vom Ausgang 71 zugeführt.

Der Strom zum Entladen des (zweiten) Kondensators 100 fließt bei der dargestellten Schaltungsanordnung über die Basis-Emitter-Strecken eines ersten und eines zweiten Emitterfolgertransistors 113 bzw. 114, die eine Impedanzwandlerstufe bilden, zum Vergleichswerteingang 63.Eine ebenfalls durch den Spannungsteiler 60, 61, 62, 90 gesteuerte, aus einem Transistor 115 und einem Widerstand 116 bestehende Stromquelle bildet eine Stromversorgung für die Impedanzwandlerstufe 113, 114. Durch die zwei hintereinander angeordneten Emitterfolgertransistoren beträgt der Strom zum Entladen des (zweiten) Kondensators 100 im Basisanschluß des ersten Emitterfolgertransistors 113 lediglich die Summe aus dem Strom im Vergleichswerteingang 63 des Differenzverstärkers 110 bis 112 und des von der Stromquelle 115, 116 geführten Stromes, geteilt durch das Produkt der Stromverstärkungen der Emitterfolgertransistoren 113 und 114. Daraus bestimmt sich der Faktor, um den der (zweite) Kondensator 100 gegenüber seiner Dimensionierung in einer Schaltungsanordnung verkleinert werden kann, in der er unmittelbar mit dem Vergleichswerteingang 63 verbunden ist. Die Kapazität des (zweiten) Kondensators 100 kann dadurch so weit verringert werden, daß eine Integration mit den übrigen Bauteilen der Schaltungsanordnung auf einem Halbleiterplättchen möglich ist, ohne dafür eine übermäßig große Fläche desselben zu benötigen.

Im Kollektorzweig des ersten Emitterfolgertransistors 113 ist wieder die Kompensationsstufe 85 angeordnet, die wie schon beschrieben aus einem Transistor besteht, dessen Basisstrom vom zweiten Ausgang 83 der Stromspiegelanordnung 77 bis 81 auf deren ersten Ausgang 82 gespiegelt wird und dort - um einen konstanten Faktor erhöht - wie beschrieben mit dem Strom zum Entladen des (zweiten) Kondensators 100 ein konstantes, nicht von den Stromverstärkungen der Transistoren abhängiges Verhältnis und so den Strom zum Aufladen des (zweiten) Kondensators 100 bildet.

**Patentansprüche**

1. Schaltungsanordnung zum Verstärken eines periodischen Signals und zum Einstellen eines darin enthaltenen Referenzpegels durch Ermittlung dieses Referenzpegels, mit einer Grenzwertstufe, in der das verstärkte Signal mit einem wenigstens nahezu konstanten Grenzwert verglichen wird und die eine Umladeanordnung wechselweise in einen von zwei Zuständen schaltet, je nachdem, ob der Wert des periodischen Signals den Grenzwert über- oder unterschreitet, wobei die Umladeanordnung Ströme zum wechselweisen Auf- oder Entladen eines Speichers derart liefert, daß auf dem Speicher ein dem Referenzpegel wenigstens annähernd entsprechender Mittelwert auftritt, und mit einer Verstärkerstufe, die wenigstens ein Verstärkerelement zum Verstärken des Signals mit einem Verstärkungsfaktor aufweist und der der Mittelwert vom Speicher zum Einstellen des im Signal enthaltenen Referenzpegels zugeführt wird, dadurch gekennzeichnet, daß die Umladeanordnung (8) dem Speicher (10) die Ströme über eine Kompensationsstufe (11) zuführt, die den Strom zum Aufladen und/oder den zum Entladen mit einem Kompensationsfaktor in der Weise umsetzt, daß einer der beiden Ströme oder beide mit dem Verstärkungsfaktor oder seinem Kehrwert derart multipliziert werden, daß der Quotient der Ströme eine Konstante ergibt.

2. Schaltungsanordnung nach Anspruch 1, dadurch gekennzeichnet, daß die Kompensationsstufe (11) wenigstens einen Transistor (43) umfaßt, dessen Stromverstärkung zu den Stromverstärkungen der Verstärkerelemente (21; 22) und/oder dem Verstärkungsfaktor ein konstantes Verhältnis bildet.

3. Schaltungsanordnung nach Anspruch 1 oder 2, dadurch gekennzeichnet, daß der Speicher (10) wenigstens einen ersten Kondensator (24) umfaßt, der außerdem einen Koppelkondensator bildet, über den das periodische Signal der Verstärkerstufe (1) zugeführt wird.

4. Schaltungsanordnung nach Anspruch 1 oder 2, dadurch gekennzeichnet, daß der Speicher (10) wenigstens einen zweiten Kondensator (100) umfaßt, der mit seinem ersten Anschluß mit einem Bezugspunkt (38) und mit seinem zweiten Anschluß mit einem Vergleichswerteingang (63) der Verstärkerstufe (50 bis 53; 110 bis 112) verbunden ist.

5. Schaltungsanordnung nach Anspruch 3 oder 4,

dadurch gekennzeichnet, daß im Verhältnis zu dem Strom zum Entladen die Kapazität des Kondensators (24; 100) derart gewählt ist, daß er durch den Strom während einer Periode des Signals nicht merklich umgeladen wird.

6. Schaltungsanordnung nach Anspruch 3 und 4 mit einem ersten (24) und einem zweiten Kondensator (100),
dadurch gekennzeichnet, daß deren Kapazitäten im Verhältnis zu den zugehörigen Strömen zum Entladen derart gewählt sind, daß Umladungen durch diese Ströme während einer Periode des Signals einander in ihren Wirkungen auf das Signal aufheben.

7. Schaltungsanordnung nach Anspruch 6,
dadurch gekennzeichnet, daß das Aufladen des ersten Kondensators (24) gegenüber dem Aufladen des zweiten Kondensators (100) in jeder Periode des Signals um einen bestimmten Bruchteil der insgesamt für die Aufladung zur Verfügung stehenden Zeitdauer verzögert ist.

8. Schaltungsanordnung nach Anspruch 4,
dadurch gekennzeichnet, daß zwischen dem zweiten Anschluß des zweiten Kondensators (100) und dem Vergleichswerteingang (63) eine Impedanzwandlerstufe (113, 114) angordnet ist.

**Claims**

1. A circuit arrangement for amplifying a periodic signal and for adjusting a reference level contained therein by determining this reference level, comprising a limit value stage in which the amplified signal is compared with an at least substantially constant limit value and which alternately switches a charging/discharging arrangement into either of two positions, depending on whether the value of the periodic signal exceeds or falls below the limit value, in which case the charging/discharging arrangement supplies currents for alternately charging or discharging a storage means such that a mean value at least substantially corresponding to the reference level occurs at the storage means, and comprising an amplifier stage which includes at least an amplifier component for amplifying the signal by an amplification factor and to which the mean value of the storage means is applied for adjusting the reference level contained in the signal, characterized in that the charging/discharging arragement (8) applies the currents to the storage means (10) *via* a compensator stage (11) converting the charging and/or discharging current by a compensation factor in such a way that one of the two currents or both currents are multiplied by the amplification factor or its reciprocal so that the quotient of the currents results in a constant.

2. A circuit arrangement as claimed in Claim 1, characterized in that the compensator stage (11) comprises at least one transistor (43) whose current gain constitutes a constant ratio to the current gains of the amplifier components (21; 22) and/or to the gain factor.

3. A circuit arrangement as claimed in Claim 1 or 2, characterized in that the storage means (10) comprises at least a first capacitor (24) forming also a coupling capacitor *via* which the periodic signal is applied to the amplifier stage (1).

4. A circuit arrangement as claimed in Claim 1 or 2, characterized in that the storage means (10) comprises at least a second capacitor (100) whose first terminal is connected to a reference point (38) and whose second terminal is connected to a comparative value input (63) of the amplifier stage (50 to 53; 110 to 112).

5. A circuit arrangement as claimed in Claim 3 or 4, characterized in that the capacitance of the capacitors (24; 100) is chosen in proportion to the discharging current in such a way that the charge of the capacitor is not changed appreciably during a signal period.

6. A circuit arrangement as claimed in Claims 3 and 4 comprising a first (24) and a second capacitor (100), characterized in that their capacitances are chosen in proportion to the associated discharging currents in such a way that changes of the change due to these currents during a signal period are cancelled as to their effects on the signal.

7. A circuit arrangement as claimed in Claim 6, characterized in that in each signal period the charging of the first capacitor (24) is delayed with respect to the charging of the second capacitor (100) by a specific fraction of the period of time available for the charging operation.

8. A circuit arrangement as claimed in Claim 4, characterized in that an impedance transformer stage (113, 114) is arranged between the second terminal of the second capacitor (100) and the comparative value input (63).

**Revendications**

1. Circuit pour amplifier un signal périodique et pour régler un niveau de référence contenu dans celui-ci par détermination de ce niveau de référence, comportant un étage à valeur de seuil dans lequel le signal amplifié est comparé avec une valeur limite au moins sensiblement constante et qui commute un dispositif de charge/décharge alternativement entre deux états selon que la valeur du signal périodique est supérieure ou inférieure à la valeur limite, le dispositif de charge/décharge fournissant des courants pour charger et décharger alternativement une mémoire de façon que sur la mémoire, apparaisse une valeur moyenne correspondant au moins pratiquement à un niveau de référence, et un étage amplificateur présentant au moins un élément amplificateur pour amplifier le signal et recevant la valeur moyenne à partir de la mémoire pour régler le niveau de référence contenu dans le signal, caractérisé en ce que le dispositif de charge/décharge (8) applique les courants à la mémoire 10 à travers un étage compensateur (11) qui convertit le courant de charge et/ou de décharge par un facteur de compensation, de telle manière que l'un des deux courants ou les deux courants soient multipliés par le facteur de multiplication ou sa valeur inverse de façon que le quotient des courants fournit une constante.

2. Circuit selon la revendication 1, caractérisé en ce que l'étage compensateur (11) comporte au moins un transistor (43) dont l'amplification de courant est dans un rapport constant avec les amplifications de courant des éléments amplificateurs (21; 22) et/ou avec le facteur d'amplification.

3. Circuit selon la revendication 1 ou 2, caractérisé en ce que la mémoire (10) comporte au moins un premier condensateur (24) qui forme en même temps un condensateur de couplage à travers lequel le signal périodique est appliqué à l'étage amplificateur (1).

4. Circuit selon la revendication 1 ou 2, caractérisé en ce que la mémoire (10) comporte au moins un second condensateur (100) qui, par sa première borne, est relié à un point de référence (38) et, par sa seconde borne, à une entrée de valeur de comparaison (63) de l'étage amplificateur (50 à 53; 110 à 112).

5. Circuit selon la revendication 3 ou 4, caractérisé en ce que, par rapport au courant de décharge, la capacité du condensateur (24; 100) est choisie de façon que le condensateur ne soit pratiquement pas soumis à des changements de charge pendant une période du signal.

6. Circuit selon les revendications 3 et 4, muni de premier (24) et second (100) condensateurs, caractérisé en ce que, par rapport aux courants associés de décharge, leurs capacités sont choisies de façon que des changements de charge provoqués par ce courant au cours d'une période de signal, se suppriment en ce qui concerne les effets qu'ils exercent sur ce signal.

7. Circuit selon la revendication 6, caractérisé en ce que, dans chaque période du signal, la charge du premier condensateur (24) est retardée par rapport à la charge du second condensateur (100) d'une fraction déterminée de la durée totale disponible pour la charge.

8. Circuit selon la revendication 4, caractérisé en ce qu'entre la seconde borne du second condensateur (100) et l'entrée de valeur de comparaison (63) est disposé un étage transformateur d'adaptation d'impédance (113, 114).

FIG.1

FIG.2

FIG. 3

FIG. 4

FIG. 5

FIG.6